# EUROPÄISCHE PATENTSCHRIFT

(11) **EP 0 690 290 B1**
(45) Veröffentlichungstag und Bekanntmachung des Hinweises auf die Patenterteilung: **05.04.2000**
(21) Anmeldenummer: 95109790.6
(22) Anmeldetag: 23.06.1995
(51) Int. Cl.: G01D 1/18, G01D 18/00

(54) **Sensor mit einer programmierbaren Schaltwelle**
Sensor with programmable threshold
Capteur avec seuil programmable

(30) Priorität: 30.06.1994 DE 4422867
(43) Veröffentlichungstag der Anmeldung: 03.01.1996
(73) Patentinhaber: Micronas Intermetall GmbH, 79108 Freiburg (DE)
(72) Erfinder: Blossfeld, Lothar, Dipl.-Phys., D-79874 Breitnau (DE)

(56) Entgegenhaltungen:
- EP-A- 0 327 824
- US-A- 5 161 405

## Beschreibung

Die Erfindung betrifft einen Sensor mit einer programmierbaren Schaltschwelle gemäß dem Oberbegriff des Patentanspruchs 1 und ein Verfahren zum Programmieren einer Schaltschwelle eines solchen Sensors. Ein solcher Sensor und ein solches Verfahren sind aus der EP 0 327 824 bekannt.

Ein sensor mit einer programmierbaren Schaltschwelle und ein Verfahren zum programmieren von Schaltschwellen sind insbesondere bei monolithisch integrierten Sensoren von Bedeutung. Als Sensoren kommen alle Sensoren in Betracht, die eine Meßgröße detektieren und ein elektrisches Signal abgeben, also insbesondere Hallsensoren, Drucksensoren, optoelektronische Sensoren, und entsprechende Schalter, wie Hallschalter etc.. Insbesondere bei der Verwendung als Schalter muß für jede Anwendung ein bestimmter Schwellenwert ausgewählt werden. Da das Herstellen von einer Vielzahl von verschiedenen Schaltertypen mit verschiedenen Schwellen teuer und umständlich ist, werden solche Sensoren programmiert bzw. ihre Schaltschwellen eingestellt.

Hierzu ist es in der Praxis üblich, auf dem Chip, auf dem der Sensor monolithisch integriert ist, ein Widerstandsnetzwerk aufzubringen, an dem der gewünschte Widerstandswert über Hilfspads oder durch Zertrennen der Verbindungsleitungen oder über zusätzliche an dem Sensorgehäuse vorgesehene Pins abgegriffen werden kann. Dieses Einstellen der Schaltschwellen kann vor dem Einbau des Sensors in ein Gehäuse vorgenommen werden. Dabei entsteht der Nachteil, daß später im Sensor mechanische Spannungen entstehen, durch welche die Schaltschwellen verändert werden. Soll die Schaltschwelleneinstellung nach dem Einbau in ein Gehäuse vorgenommen werden können, müssen die Chips wegen der erforderlichen Zusatzpads großflächiger ausgelegt werden, und die Gehäuse müssen entsprechend groß oder mit zusätzlichen Pins hergestellt werden.

Der Erfindung liegt die Aufgabe zugrunde, einen Sensor mit einer programmierbaren Schaltschwelle und ein Verfahren zum Programmieren einer Schaltschwelle des Sensors mit der Möglichkeit eines einfachen und zuverlässigen Programmierens zu schaffen.

Diese Aufgabe wird durch einen Sensor mit den Merkmalen des Patentanspruchs 1 gelöst.

Ferner wird die Erfindung durch ein Verfahren mit den Merkmalen des Patentanspruchs 7 gelöst. Zur Erzeugung des Stromsignals kann als Stromsignalgenerator vorzugsweise ein D/A-Wandler mit Stromausgang verwendet werden. Letzterer kann dann ein sich stufenweise änderndes, d.h. anwachsendes oder abnehmendes Stromsignal erzeugen. Der Code wird so gewählt, daß er in einer Richtung der Änderung des Stromsignales eine eindeutige Zuordnung bewirkt. Es wird dabei ein digitaler Code verwendet, z.B. eine aufsteigende oder absteigende Zahlenfolge. Das Meßausgangssignal wird aufgrund einer vorbestimmten Meßgröße erzeugt. So kann z.B. bei einem Hallschalter ein festes Magnetfeld angelegt werden, bei welchem eine Schaltschwelle des Sensors liegen soll. Es kann so z.B. der Einschaltzustand eines Hallsensors programmiert werden. Die Übernahme des Codes in die Speichereinheit erfolgt dann, wenn das Stromsignal und das Meßausgangssignal gleich groß sind, so daß der Komparator umschaltet und somit der Speichereinheit ein entsprechendes Übernahmesignal zugeführt wird. Als Speichereinheit kann beispielsweise ein OTP (one time programmable)-Speicher verwendet werden.

Mit einem solchen Sensor und mit einem solchen Verfahren ist eine Programmierung einer Schaltschwelle des Sensors auf einfache und zuverlässige Weise möglich. Die Programmierung der Schaltschwelle erfolgt durch Anlegen einer Meßgröße und Abgleichen von dadurch erzeugten elektrischen Signalen mit den erzeugten Stromsignalen in dem Komparator. Die Programmierung kann somit an dem Einsatzort nach dem Einbau des Sensors bzw. des Chips vorgenommen werden. Dadurch wird ein Verstellen der Schwellen aufgrund von auftretenden mechanischen Spannungen vermieden. Zudem kann bei Änderungswünschen die Programmierung des Sensors wieder geändert werden. Dies ist dann möglich, wenn die Speichereinheit gelöscht wird. Bei der Verwendung eines OTP- Speichers ist dies durch UV-Licht möglich. Auch sind bei der erfindungsgemäßen Art der Programmierung keine zusätzlichen äußeren Pins an dem Sensor bzw. dem Sensorgehäuse erforderlich.

Gemäß einer vorteilhaften Weiterbildung der Erfindung ist der Ausgang des Komparators mit einem Stopsignaleingang der Zähleinheit verbunden, welche zum Weiterleiten des Übernahmesignals mit der Speichereinheit verbunden ist. Somit kann die Zähleinheit nach Beenden der Programmierung einer Schaltschwelle gestoppt werden. Günstigerweise kann ein Programmiercode-Eingang mit einem Starteingang der Zähleinheit verbunden sein. Dann kann an dem Programmiercode-Eingang von dem Benutzer ein Programmiercode eingegeben werden, mit dem die Zähleinheit und damit das Programmierverfahren gestartet wird. Für das Programmieren verschiedener Schwellen können dabei unterschiedliche Programmiercodes vorgesehen sein. Der Programmiercode wird dabei günstigerweise als eine VDD-überlagerte Impulsfolge eingegeben.

Vorteilhafterweise kann zwischen dem Programmiercode-Eingang und der Speichereinheit eine Speicherwert-Einfrierlogik vorgesehen sein. Diese Einfrierlogik dient dazu, den von der Speichereinheit übernommenen aktuellen Wert in einem nichtflüchtigen Speicher zu speichern. Dann wird der Speicherwert auch bei Abschalten der Versorgungsspannung von dem Sensor in der Speichereinheit behalten. Bei Verwendung eines OTP-Speichers kann das Speichern durch anlegen eines hohen Spannungssignals an dem Programmiercode-Eingang erfolgen. In diesem Fall kann die Einfrierlogik ein Schaltelement sein, das beim Überschreiten eines Spannungswertes in den leitenden Zustand übergeht. Dies ist nur dann sinnvoll, wenn der Sensor bei einer Versorgungsspannung unterhalb der für die Speicherung erforderlichen Spannung betrieben wird. Wird der Sensor oberhalb der für das Speichern in der Speichereinheit erforderlichen Spannung betrieben, so kann die Einfrierlogik z.B. auf ein bestimmtes an dem Programmiercode-Eingang angelegtes Signal, insbesondere in Form einer Impulsfolge, reagieren.

Gemäß einem weiteren Ausführungsbeispiel der Erfindung kann in der Speichereinheit ein Adreßcode speicherbar sein, und den Sensor ein Schaltelement umfassen, von welchen je ein Eingang mit einem Adressenregister, der Speichereinheit und der Betriebsspannungsversorgung verbunden ist, und welches derart ausgebildet ist, daß bei Übereinstimmung dieses gespeicherten Adreßcodes mit einem über das Adressenregister eingegebenen Adreßcode das Signal der Betriebsspannungsversorgung durchschaltbar und dem Sensorelement, dem Komparator und dem Stromsignalgenerator zuführbar ist. Somit ist der Schalter über einen Adresscode ansprechbar. Die Adresse kann über die VDD-Spannungsleitung angesprochen werden, und aktiviert den Sensor. Der Sensor kann dann drei Zustände aufweisen, einen Standby-Zustand, einen niederenergetischen Zustand und einen hochenergetischen Zustand. Der Standby-Zustand liegt dann vor, wenn der Sensor aktiv ist, aber seine Adressen nicht angesprochen wird. Dann liegt die Betriebsspannung lediglich an den Teilen vor dem Schaltelement, insbesondere der Codiereinheit und der Speichereinheit an. An den übrigen Sensorteilen, die hinter dem Schaltelement angeordnet sind, insbesondere dem Referenzsignalgenerator, dem Hallelement und dem Komparator, liegt die Versorgungsspannung nicht an. Diese wird an die letzten Elemente nur dann angelegt, wenn der Sensor angesprochen wird und somit das Schaltelement durchschaltet.

Günstigerweise kann der Ausgang des Komparators auf eine ansteuerbare Stromquelle geführt sein, über welche das Sensorelement ansteuerbar ist. Somit erhält man einen Zweidraht-Sensor.

Das Speichern eines Adreßcodes ist dann sinnvoll, wenn der Sensor in einem System von Sensoren verwendet wird. Dabei können die Sensoren auch Zweidraht-Sensoren sein, welche über einen Eingangstransistor angesprochen werden können.

Der Adreßcode kann dann das Transistorgate ansteuern. Das Ansprechen der Sensoren mit dem programmierten Adreßcode kann durch eine der VDD-Betriebsspannung positiv überlagerten Spannungsimpulsfolge erfolgen, da dadurch der entsprechende Sensor auch noch bei einer sehr geringen Batteriespannung arbeitsfähig ist. Bei der Anordnung mit einem Eingangstransistor kann das Ausgangssignal des entsprechenden Sensors an dem Kollektor entnommen werden. Man erhält somit die Ausgangsinformation des hohen oder niedrigen Energiezustandes oder des Standby-Zustandes. Diesen Ausgangsinformationen können drei verschiedene Stromwerte entsprechen. Die erfindungsgemäßen Zweidraht-Sensoren können in einem Bussystem verwendet werden, wobei sowohl die Schwellen als auch die Busadressen der jeweiligen Sensoren programmiert werden.

Ferner ist der erfindungsgemäße Sensor bzw. dessen Programmierung in einem Sensorsystem, in dem Magnetfelder gemessen werden, vorteilhaft. Denn ein Magnet, dessen Feld von dem Sensor gemessen werden soll, kann ausgetauscht werden, und der Sensor kann dann durch neues Programmieren der Schaltschwellen an den neuen Magneten angepaßt werden, ohne daß der Sensor oder das komplette.System ausgetauscht werden muß.

Bei der Verwendung von erfindungsgemäßen Hallsensoren aus Silizium in Bussystemen wird auch die Verdrahtung des Systems vereinfacht, was eine erhöhte Zuverlässigkeit und einen günstigeren Preis zur Folge hat.

Es lassen sich auch analoge Sensoren, z.B. Hallelemente, in denen ein digitales System (Clock) integriert ist, in ein solches System einfügen. Die analogen Werte können dann infolge einer Codierung als digitaler Datenstrom ausgegeben werden. Dies kann ins System zur Kontrolle von Magnetfeldern von magnetisierten Metalloberflächen, wie Schweißnahtkontrollen, oder in der Orts-, Geschwindigkeits- bzw. Beschleunigungsmesssung von Objekten oder zur Objekterkennung von magnetischen Gegenständen in der Industrieautomatisation vorteilhaft sein. Auch können der erfindungsgemäße Sensor und das erfindungsgemmäße Verfahren bei einem Differentialsensor verwendet werden. Es kann z.B die Differenz eines Magnetfeldes von zwei auf einen Chip angeordneten Hallsensorelementen gemessen und ausgewertet werden. Eine in dem System vorhandene Felddifferenz, die sogenannte Präinduktion, welche zu einem Offset führt, kann durch ein geeignetes Programmieren der Schwellen eliminiert werden.

Ferner ist es zur Durchführung des erfindungsgemäßen Verfahrens günstig, wenn zum Programmieren einer ersten Schaltschwelle des Sensors die Änderung des Meßausgangssignals einem Erhöhen des Referenz- bzw. Stromsignals und der Code einer aufsteigenden Zahlenfolge entspricht. Somit kann die Schwelle zum Einschalten des als Schalter verwendeten Sensors programmiert werden. Zum Programmieren einer zweiten Schaltschwelle kann die Änderung des Meßausgangssignals einem Erniedrigen des Stromsignals, ausgehend vom dem der ersten Schaltschwelle entsprechenden Stromsignal und dem Code eine abnehmenden Zahlenfolge, ausgehend von der der ersten Schaltschwelle zugeordneten Zahl, entsprechen. So kann die Schwelle zum Ausschalten des Sensors ausgehend von der ersten Schaltschwelle zum Einschalten des Sensors programmiert werden. Dabei dient der Schwellenwert zum Einschalten als ein Bezugspunkt, so daß der Stromsignalgenerator sein Signal in diesem Fall in der Differenz verändert. Dadurch wird eine größere Genauigkeit erzielt. Der Stromsignalgenerator kann also so ausgebildet sein, daß er für das erste Stromsignal für die erste Schaltschwelle einen Absolutwert und für das zweite Stromsignal für die zweite Schaltschwelle einen Differenzwert verändert. Voraussetzung ist, daß die Differenz immer kleiner als der Absolutwert ist, auch wenn der Absolutwert sein Vorzeichen ändert, damit eine Oszillation des Komparators vermieden wird. Bei einem Hallsensor, welcher als Schalter eingesetzt wird, sind bei diesem Verfahren der Einschaltzustand und seine Hysterese frei wählbar.

Im folgenden wird die Erfindung anhand der Zeichnung näher beschrieben.

Es zeigen:
Fig. 1 ein ersten Ausführungsbeispiels des erfindungsgemäßen Sensors, bei dem zwei Schwellenwerte programmierbar sind und
Fig. 2 ein zweites Ausführungsbeispiels des erfindungsgemäßen Sensors als Zweidraht-Sensor, bei dem zwei Schwellenwerte und ein Adreßcode programmierbar sind.

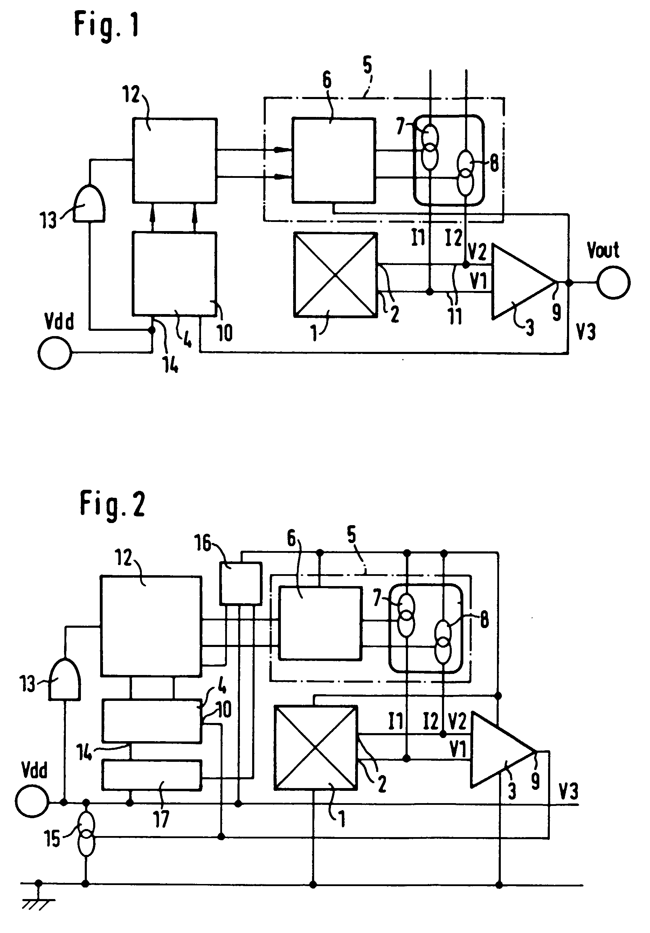

In Fig. 1 ist als Ausführungsbeispiel eines erfindungsgemmäßen Sensors ein als Schalter verwendeter Hallsensor dargestellt. Der Hallsensor weist ein Hall-Sensorelement 1 auf, dessen Meßausgangsklemmen 2 mit einem Komparator 3 verbunden sind. Zum Programmieren der Schaltschwellen des Sensors wird in dem Meßbereich des Hall-Sensorelements 1 ein in der Figur nicht gezeigter Magnet mit einem vorbestimmmten Magnetfeld angeordnet, welches die erste Schaltschwelle des Sensors bestimmt. Zur Programmierung dieser Schaltschwelle wird über eine Codiereinheit, die im folgenden als Zähleinheit 4 bezeichnet wird, der Stromsignalgenerator 5 angesteuert. Die Zähleinheit 4 wird durch Anlegen eines ersten Impulsfolgesignals gestartet. Dabei besteht der Stromsignalgenerator 5 aus einem D/A-Wandler 6 und zwei mit dessen Ausgängen verbundenen Stromquellen 7 und 8. Wesentlich dabei ist, daß mit dem Stromsignalgenerator 5 zwei Stromsignale I1, I2 erzeugbar sind. Die Ströme I1, I2 können dabei auch von dem D/A-Wandler selbst erzeugt werden. Mit dem Stromsignalgenerator 5 kann der Ausgangsstrom I1 stufenweise erhöht werden, wobei die einzelnen Stufen von der Zähleinheit 4 gezählt werden. Der Strom I1 des Stromsignalgenerators 5 wird dem Ausgangssignal des Hall-Sensorelements 1 überlagert. Das Ausgangssignal V1, V2 des Hall-Sensorelements 1 ist durch das von außen angelegte Magnetfeld bestimmt. Der Ausgang 9 des Komparators 3 wird auf den Stoppeingang 10 der Zähleinheit 4 geführt. Wenn der Strom I1 des Stromsignalgenerators 5 so groß wird, daß er die Ausgangsspannung V1 des Hall-Sensorelements 1 kompensiert, klappt der Zustand des Ausgangssignals des Komparators 3 um. Aufgrund dieses Umklappens wird die Zähleinheit 4 gestoppt und die in der Zähleinheit 4 aktuelle Zahl der Speichereinheit 12 übergeben und dort abgespeichert. Zum Speichern dieses Zahlenwertes in einem nicht flüchtigen Zustand ist eine Einfrierlogik 13 zwischen dem Starteingang 14 der Zähleinheit 4 und der Speichereinheit 12 vorgesehen. Wenn an den Eingang Vdd der Betriebsspannung ein bestimmtes Spannungssignal angelegt wird, wird das Signal über die Einfrierlogik 13 an die Speichereinheit 12 weitergeleitet, und der dort gespeicherte Zahlenwert für die erste Schwelle gespeichert.

Mit der zweiten Stromquelle 8 des Stromsignalgenerators 5 wird ein Strom I2 erzeugt, der dem Spannungssignal V2 des Hall-Sensorelements 1 überlagert wird. Mit der Stromquelle 8 kann der Strom ausgehend von dem in der Speichereinheit 12 gespeicherten ersten Schwellenwert stufenweise aufgrund der Ansteuerung der Zähleinheit 4 und dem D/A-Wandler 6 erniedrigt werden. Den einzelnen Stufen der Stromerniedrigung des Stroms I2 wird in der Zähleinheit 4 eine absteigende Zahlenfolge zugeordnet. Die Zähleinheit 4 wird durch Anlegen eines zweiten, von dem ersten Impulsfolgesignals verschiedenen Signal gestartet. Das zweite Stromsignal I2 wird der aufgrund eines zweiten äußeren Magneten angelegten Magnetfeldes erzeugten Ausgangsspannung V2 des Hall-Sensorelements 1 überlagert. Wenn der Strom I2 die Ausgangsspannung V1, V2 des Hall-Sensorelements 1 kompensiert, klappt der Zustand des Ausgangssignals des Komparators 3 um und stoppt durch Zuführen des Signales an den Signaleingang 10 die Zähleinheit 4. Über eine Verbindungsleitung zwischen dem Ausgang des Komparators 3 und dem D/A-Wandler 6 wird ein Steuersignal gegeben, von dem entweder die Stromquelle 7 oder die Stromquelle 8 angesteuert wird.

Der aktuelle Zahlenwert der Zähleinheit 4 wird der Speichereinheit 12 übergeben und dort in einem zweiten Speicher gespeichert. Das Überführen in den nichtflüchtigen Zustand des Speicherwertes erfolgt wieder durch Anlegen eines vorgegebenen Spannungssignales an den Spannungseingang Vdd über die Einfrierlogik 13. Die Steuerung des Stromsignalgenerator 5, der Zähleinheit 4 und der Einfrierlogik 13 erfolgt mit einer in der Figur nicht gezeichneten Steuereinrichtung.

Die Fig. 2 zeigt ein zweites Ausführungsbeispiel des erfindungsgemäßen Sensors. Elemente die denen der Fig. 1 entsprechen sind mit gleichen Bezugszeichen bezeichnet. Da die gleichen Elemente die gleichen Funktion haben wie in Fig. 1, werden im folgenden nur die Unterschiede bzw. zusätzlichen Elemente beschrieben.

Bei dem vorliegenden Sensor handelt es sich um einen Zweidrahtsensor. Der Ausgang 9 des Komparators 3 ist mit einer ansteuerbaren Stromquelle 15 verbunden. Das Ausgangssignal V3 des Komparators 3 steuert die Stromquelle 15, so daß aus deren Stromwert der Zustand des Komparators 3 entnommen werden kann. Zwei Schwellen des Hall-Elementes 1, bei denen es Ein- bzw. Ausschalten soll, werden wie im Zusammenhang mit Fig. 1 beschrieben, programmiert. Es wird jeweils ein vorgegebenes Magnetfeld in den Meßbereich des Hall-Sensorelements 1 gebracht. Dann wird mit dem Stromsignalgenerator 5 der Strom I1, bzw. I2 so lange variiert, bis die aufgrund des anliegenden Magnetfeldes vorhandene Hallspannung V1 bzw. V2, welche an dem Komparator 3 anliegt, kompensiert wird. Dann ändert sich das Ausgangssignal V3 des Komparators 3, und in folgedessen wird die Zähleinheit 4 gestoppt und die darin vorhandene aktuelle Zahl bzw. Code von der Speichereinheit 12 übernommen und dort gespeichert. Im Falle eines Hallschalters enthält die Speichereinheit 12 zwei Speicherwerte, welche dem Einschalt- und dem Ausschaltzustand des Hall-Sensors entsprechen. Bei dem hier gezeigten Ausführungsbeispiel kann außer den Schaltschwellen noch ein Adreßcode abgespeichert werden, über welchen eine Identifizierung des Sensors möglich ist. Der Adreßcode wird in einem dritten Speicherbereich der Speichereinheit 12 abgespeichert. Die Eingabe des Adreßcodes kann über ein an dem Betriebsspannungseingang Vdd angelegtes Signal, z.B. mit einer der positiven Betriebsspannung überlagerten Impulsfolge, eingegeben werden. Das Speichern in einem nichtflüchtigen Zustand in der Speichereinheit 12 erfolgt dann wie im Zusammenhang mit Fig. 1 bezüglich der Schaltschwellen beschrieben, mittels der Einfrierlogik 13.

Zwischen der Speichereinheit 12 und dem Stromsignalgenerator 5 ist ein Schaltelement 16 angeordnet. Ferner ist zwischen dem Eingang für die positive Betriebsspannung Vdd und dem Schaltelement 16 ein Adressenregister 17 vorgesehen. Ein in der Betriebsspannung enthaltener Code für die Adresse des Sensors wird jeweils dem Adressenregister 17 übergeben. Ein Ausgang des Adressenregisters 17 ist über die Zähleinheit 4 mit der Speichereinheit 12 verbunden, so daß die oben beschriebene Adressenspeicherung über das Adressenregister 17 erfolgen kann. Ein weiterer Ausgang des Adressenregisters 17 ist mit einem Eingang des Schaltelements 16 verbunden. Ein weiterer Eingang des Schaltelements 16 ist direkt mit der positiven Betriebsspannung Vdd verbunden. Das Schaltelement 16 ist derart ausgebildet, daß es, wenn das ihm von der Speichereinheit 12 zugeführte Signal mit dem von dem Adressenregister 17 zugeführten Signal übereinstimmt, das von der positiven Betriebsspannung Vdd kommende Signal auf den Ausgang und somit auf den Stromsignalgenerator bzw. die danach folgenden Schaltelemente, d.h. das Hall-Sensorelement 1 und den Komparator 3, durchschaltet. Wenn also mit der positiven Betriebsspannung Vdd ein Adresssignal eingegeben wird, so gelangt dieses über das Adressenregister 17 zu dem Schaltelement 16 und wird dort mit dem in der Speichereinheit 12 gespeicherten Adreßcode verglichen. Wenn der eingegebenen Adreßcode mit dem gespeicherten Wert übereinstimmt, wird über das Schaltelement 16 die Betriebsspannung Vdd dem Stromsignalgenerator 5, dem Hall-Sensorelement 1 und dem Komparator 3 zugeführt. In diesem Fall, in dem der Sensor von außen angesprochen wird, werden also alle Elemente des Sensors aktiviert. Damit ist der Sensor aktiv und spricht bei Anliegen eines Magnetfeldes bei den programmierten Schaltschwellen an. Wenn der Sensor nicht aufgrund eines äußeren Signales angesprochen wird, unterbricht das Schaltelement 16 die von dem Vdd-Eingang kommende Betriebsspannung. Somit liegt die Betriebsspannung Vdd nicht an dem Stromsignalgenerator 5, dem Hall-Sensorelement 1 und dem Komparator 3 an, und der Sensor befindet sich in einem Standby-Zustand. Ein solcher Sensor wird insbesondere in einem System von Sensoren, z.B. Bussystemen, verwendet. In einem solchen System werden dann alle Sensoren, deren Adresse nicht angesprochen wird, in den Standby-Zustand gesetzt. Ein solcher Sensor hat drei Ausgangszustände, die aufgrund des Stromwertes der Stromquelle 15 meßbar sind. Dies ist ein hoher und ein niedriger Stromzustand entsprechend den Schwellwerten und der Standby-Zustand, dessen Stromwert unterhalb der beiden anderen liegt. Der Zustand des Sensors ist von einer Auswerteelektronik sofort erkennbar. Diese kann auch feststellen, wenn ein aktiver Sensor von einem Störimpuls ausgeschaltet wird.

## Patentansprüche

1. Sensor mit einer programmierbaren Schaltschwelle mit einem Sensorelement (1), mit einem Komparator (3), auf den die Meßausgangsklemmen des Sensorelements (1) geführt sind, mit einem Signalgenerator (5) zum Erzeugen eines Referenzsignals, mit einer Speichereinheit (12), mit einer Codiereinheit (4) *und mit einer Steuereinrichtung zur Steuerung des Signalgenerators (5) und der Codiereinheit (4)*
dadurch gekennzeichnet,
daß der Signalgenerator *ein Stromsignalgenerator ist, welcher* so ausgebildet ist, daß durch diesen *während des Programmiervorgangs* ein Stromsignal (I1, I2) erzeugbar ist, welches *stufenweise erhöht oder stufenweise erniedrigt werden kann und* dem Komparator (3) zum Einstellen der Schaltschwelle zuführbar ist,
*und die* Codiereinheit (4) *so ausgebildet ist, daß* mit *ihr* den *jeweiligen* Werten des *sich stufenweise erhöhenden oder sich stufenweise erniedrigenden* Stromsignals ein Code zuordenbar ist, *wobei die Codiereinheit (4) während des Programmiervorgangs* mit der Speichereinheit zur Übergabe *des* der Schaltschwelle zugeordneten Codes verbunden ist, wobei der Ausgang (9) des Komparators (3) zur Abgabe eines Übernahmesignals (V3) für den *der Schaltschwelle zugeordneten* Code, wenn das *Stromsignal (I1, I2)* mit dem Ausgangssignal des Sensorelements (1) übereinstimmt, mit der Speichereinheit (12) so gekoppelt ist, daß der der zu programmierenden Schaltschwelle entsprechende Code *während des Programmiervorgangs* speicherbar ist.

2. Sensor nach Anspruch 1, dadurch gekennzeichnet, daß der Ausgang (9) des Komparators (3) mit einem Stoppsignaleingang (10) der Codiereinheit (4) verbunden ist, welche zum Weiterleiten des Übernahmesignals mit der Speichereinheit (12) verbunden ist.

3. Sensor nach Anspruch 1 oder 2, dadurch gekennzeichnet, daß ein Programmiercode-Eingang (Vdd) *des Sensors* mit einem Starteingang (14) der Codiereinheit verbunden ist.

4. Sensor nach *Anspruch 3,* dadurch gekennzeichnet, daß zwischen dem Programmiercodeeingang (Vdd) und der Speichereinheit (12) eine Speicherwert-Einfrierlogik (13) vorgesehen ist, welche von der Steuereinrichtung angesteuert wird.

5. Sensor nach einem der Ansprüche 3 *oder 4,* dadurch gekennzeichnet, daß in der Speichereinheit (12) ein Adreßcode speicherbar ist, und *der Sensor* ein Schaltelement (16) *umfaßt,* von welchem je ein Eingang mit *einem Adressenregister (17),* der Speichereinheit (12) und *der* Betriebsspannungsversorgung (Vdd) verbunden ist, und welches *derart ausgebildet ist, daß* bei Übereinstimmung des gespeicherten Adreßcodes mit einem über *das Adressenregister (17)* eingegebenen Adreßcode das Signal der Betriebsspannungsversorgung durchschalt*bar* und dem Sensorelement (1), dem Komparator (3) und dem Stromsignalgenerator (5) *zuführbar ist.*

6. Sensor nach einem der Ansprüche 1 bis 5, dadurch gekennzeichnet, daß der Ausgang (9) des Komparators (3) auf eine ansteuerbare Stromquelle (15) geführt ist, über welche das Sensorelement (1) ansteuerbar ist.

7. Verfahren zum Programmieren einer Schaltschwelle eines Sensors, dadurch gekennzeichnet, daß eine zum Programmieren der Schaltschwelle *vor*bestimmte Meßgröße an ein Sensorelement (1) angelegt wird, das so erzeugte Meßausgangssignal des Sensorelements (1) mit einem sich während des Programmiervorgangs in Schritten *erhöhenden oder erniedrigenden* Referenzsignal verglichen wird, und wenn das Meßausgangssignal dem Referenzsignal entspricht, dem Wert des Referenzsignals ein Code zugeordnet wird, durch den die programmierte Schaltschwelle bestimmt wird.

8. Verfahren nach Anspruch 7, dadurch gekennzeichnet, daß zum Programmieren einer ersten Schaltschwelle die Änderung *des Meßausgangssignals* einem Erhöhen des *Referenz- bzw.* Stromsignals und der Code einer aufsteigenden Zahlenfolge entspricht.

9. Verfahren nach Anspruch 7 oder 8, dadurch gekennzeichnet, daß zum Programmieren einer zweiten Schaltschwelle die Änderung *des Meßausgangssignals* einem Erniedrigen des *Referenz- bzw.* Stromsignals, ausgehend von dem der ersten Schaltschwelle entsprechenden Stromsignal und der Code einer abnehmenden Zahlenfolge ausgehend von der der ersten Schaltschwelle zugeordneten Zahl entspricht.

10. Verfahren nach einem der Ansprüche 7 bis 9, dadurch gekennzeichnet, daß das Programmieren der Schaltschwellen durch Eingabe eines der jeweiligen Programmierung zugeordneten Codes, insbesondere einer Impulsfolge, gestartet wird.

11. Verfahren nach einem der Ansprüche 7 bis 10, dadurch gekennzeichnet. daß ein dem Sensor zugeordneter Adreßcode gespeichert wird, welcher bei Eingabe eines gewählten Adreßcodes mit diesem verglichen wird, daß der Sensor bei Übereinstimmung des gespeicherten und des gewählten Adreßcodes aktiviert wird, und bei Nichtübereinstimmung in einen Standby-Zustand gesetzt wird.

12. Verfahren nach Anspruch 10 oder 11, dadurch gekennzeichnet, daß der der jeweiligen Programmierung zugeordnete Code bzw. der gewählte Adreßcode als eine einer positiven Betriebsspannung überlagerte Impulsfolge eingegeben wird.

## Revendications

1. Capteur à seuil de commutation programmable, comportant un élément capteur (1), un comparateur (3), auquel sont reliées les bornes de sortie de mesure de l'élément capteur (1), un générateur de signaux de courant (5) pour produire un signal de référence, une unité de mémoire (12), une unité de codage (4) *et un dispositif de commande pour la commande du générateur de signaux de courant (5) et de l'unité de codage (4),*
caractérisé en ce que
le générateur de signaux *est un générateur de signaux de courant qui* est conformé de telle manière que ce dernier peut produire, *pendant l'opération de programmation,* un signal de courant (I1, I2) qui *peut être augmenté par degrés ou diminué par degrés et* qui peut être envoyé au comparateur (3) pour le réglage du seuil de commutation
*et* l'unité de codage (4) *est conformée de telle manière que,* au moyen de *cette dernière,* on peut associer un code aux valeurs *respectives* du signal de courant *qui augmente par degrés ou diminue par degrés, l'unité de* codage (4) étant reliée, *pendant l'opération de programmation,* à l'unité de mémoire pour la transmission du code associé au seuil de commutation, la sortie (9) du comparateur (3) étant, pour la délivrance d'un signal de prise en charge (V3) pour le code associé *au seuil de commutation,* lorsque le *signal de courant (I1, I2*) correspond au signal de sortie de l'élément capteur (1), couplée avec l'unité de mémoire (12) de telle manière que le code correspondant au seuil de commutation en cours de programmation peut être mémorisé *pendant l'opération de programmation.*

2. Capteur selon la revendication 1, caractérisé en ce que la sortie (9) du comparateur (3) est reliée à une entrée de signal d'arrêt (10) de l'unité de codage (4) qui est reliée à l'unité de mémoire (12) pour la transmission du signal de prise en charge.

3. Capteur selon la revendication 1 ou 2, caractérisé en ce qu'une entrée de code de programmation (Vdd) *du capteur* est reliée à une entrée de démarrage (14) de l'unité de codage.

4. Capteur selon *la revendication 3,* caractérisé en ce que, entre l'entrée de code de programmation (Vdd) et l'unité de mémoire (12), on prévoit une unité logique de fixation de la valeur de mémoire (13) qui est commandée par le dispositif de commande.

5. Capteur selon l'une des revendications 3 *ou 4,* caractérisé en ce que, dans l'unité de mémoire (12), on peut mémoriser un code d'adresse et en ce que *le capteur comprend* un élément de commutation (16) dont, à chaque fois, une entrée est reliée à *un registre d'adresses (17),* à l'unité de mémoire (12) et à l'alimentation de la tension de service (Vdd) et qui *est conformé de telle manière que,* lors de la correspondance du code d'adresse mémorisé avec un code d'adresse entré par l'intermédiaire *du registre d'adresses (17),* le signal de l'alimentation de la tension de service *peut être* commuté et *peut être envoyé* à l'élément capteur (1), au comparateur (3) et au générateur de signaux de courant (5).

6. Capteur selon l'une quelconque des revendications 1 à 5, caractérisé en ce que la sortie (9) du comparateur (3) est envoyée sur une source de courant (15) pouvant être commandée et par l'intermédiaire de laquelle l'élément capteur (1) peut être commandé.

7. Procédé pour la programmation d'un seuil de commutation d'un capteur, caractérisé en ce que l'on applique une grandeur de mesure *pré*déterminée pour la programmation du seuil de commutation à un élément capteur (1), en ce que le signal de sortie de mesure, ainsi produit, de l'élément capteur (1) est comparé avec un signal de référence *qui augmente ou diminue* par degrés pendant l'opération de programmation et en ce que, si le signal de sortie de mesure correspond au signal de référence, on associe, à la valeur du signal de référence, un code par l'intermédiaire duquel on détermine le seuil de commutation programmé.

8. Procédé selon la revendication 7, caractérisé en ce que, pour la programmation d'un premier seuil de commutation, la modification *du signal de sortie de mesure* correspond à une augmentation du *signal de référence ou* du signal de courant et le code correspond à une suite de nombres croissants.

9. Procédé selon la revendication 7 ou 8, caractérisé en ce que, pour la programmation d'un deuxième seuil de commutation, la modification *du signal de sortie de mesure* correspond à une diminution du *signal de référence ou* du signal de courant, à partir du signal de courant correspondant au premier seuil de commutation et le code correspond à une suite de nombres décroissants, à partir du nombre associé au premier seuil de commutation.

10. Procédé selon l'une quelconque des revendications 7 à 9, caractérisé en ce que la programmation des seuils de commutation est démarrée par introduction d'un code associé à la programmation respective, en particulier à une suite d'impulsions.

11. Procédé selon l'une quelconque des revendications 7 à 10, caractérisé en ce que l'on mémorise un code d'adresse associé au capteur et qui, lors de l'introduction d'un code d'adresse sélectionné, est comparé à ce dernier, en ce que le capteur est activé dans le cas de la coïncidence du code d'adresse mémorisé et du code d'adresse sélectionné et est mis en état de veille dans le cas de non coïncidence

12. Procédé selon la revendication 10 ou 11, caractérisé en ce que le code associé à la programmation respective ou le code d'adresse sélectionné est introduit sous la forme d'une suite d'impulsions superposées à une tension de service positive.

## Claims

1. A sensor with a programmable switching threshold, comprising a sensing element (1), a comparator (3) connected to the measurement output terminals of the sensing element (1), a signal generator (5) for generating a reference signal, a memory unit (12), an encoding unit (4), and a control facility for controlling the signal generator (5) and the encoding unit (4),
characterized in
that the signal generator is a current-signal generator designed to generate during the programming process a current signal (I1, I2) which can be increased in steps or decreased in steps and can be applied to the comparator (3) for setting the switching threshold, that the encoding unit (4) is designed to assign a code to the respective values of the stepwise increasing or stepwise decreasing current signal and, during the programming process, is connected to the memory unit for transferring the code assigned to the switching threshold, with the output (9) of the comparator (3) providing an enable signal (V3) permitting the transfer of the code assigned to the switching threshold when the current signal (I1, I2) matches the output signal of the sensing element (1), and being coupled to the memory unit (12) so that the code corresponding to the switching threshold to be programmed is storable during the programming process.

2. A sensor as claimed in claim 1, characterized in that the output (9) of the comparator (3) is coupled to a stop-signal input (10) of the encoding unit (4), which is connected to the memory unit (12) for transferring the enable signal.

3. A sensor as claimed in claim 1 or 2, characterized in that a programming-code input (Vdd) of the sensor is connected to a start input (14) of the encoding unit.

4. A sensor as claimed in claim 3, characterized in that a memory value freeze logic (13) controlled by the control unit is provided between the programming-code input (Vdd) and the memory unit (12).

5. A sensor as claimed in claim 3 or 4, characterized in that an address code is storable in the memory unit (12), and that the sensor comprises a switching element (16) having three inputs connected to an address register (17), to the memory unit (12), and to the power supply (Vdd), respectively, and designed in such a way that, when the stored address code matches an address code entered via the address register (17), the signal from the power supply can be switched through and applied to the sensing element (1), the comparator (3), and the current-signal generator (5).

6. A sensor as claimed in any one of claims 1 to 5, characterized in that the output (9) of the comparator (3) is coupled to a controlled current source (15) via which the sensing element (1) is controllable.

7. A method of programming a switching threshold of a sensor, characterized in that a measured quantity predefined for programming the switching threshold is fed to a sensing element (1), that the measurement output signal of the sensing element (1) thus generated is compared with a reference signal increasing or decreasing in steps during the programming process, and that, when the measurement output signal matches the reference signal, the value of the reference signal is assigned a code by which the programmed switching threshold is determined.

8. A method as claimed in claim 7, characterized in that, to program a first switching threshold, the change of the measurement output signal corresponds to an increase of the reference or current signal, and the code to an ascending number sequence.

9. A method as claimed in claim 7 or 8, characterized in that, to program a second switching threshold, the change of the measurement output signal corresponds to a decrease of the reference or current signal starting from the current signal corresponding to the first switching threshold, and the code corresponds to a descending number sequence starting from the number assigned to the first switching threshold.

10. A method as claimed in any one of claims 7 to 9, characterized in that the programming of the switching thresholds is started by entering a code assigned to the respective threshold, particularly a pulse sequence.

11. A method as claimed in any one of claims 7 to 10, characterized in that an address code assigned to the sensor is stored and, when a selected address code is entered, is compared with the latter, and that the sensor is activated in case of agreement between the stored address code and the selected address code, and set to a standby state in case of disagreement.

12. A method as claimed in claim 10 or 11, characterized in that the code assigned to the respective switching threshold, or the selected address code, is entered as a pulse sequence superimposed on a positive supply voltage.
